# EUROPEAN PATENT APPLICATION

(11) **EP 4 415 049 A1**
(43) Date of publication of application: **14.08.2024**
(21) Application number: 23796603.1
(22) Date of filing: 07.03.2023
(51) Int. Cl.: H01L 27/15, H01L 27/12, H01L 25/075, H01L 33/48, H01L 33/62, H01L 33/36, H01L 23/00

(54) **DISPLAY MODULE**

(30) Priority: 27.04.2022 KR 20220052135; 03.06.2022 KR 20220068283
(71) Applicant: Samsung Electronics Co., Ltd., Suwon-si, Gyeonggi-do 16677 (KR)
(72) Inventor: PARK, Sangmoo, Suwon-si, Gyeonggi-do 16677 (KR); KIM, Donghwan, Suwon-si, Gyeonggi-do 16677 (KR); LEE, Donghun, Suwon-si, Gyeonggi-do 16677 (KR); JUNG, Youngki, Suwon-si, Gyeonggi-do 16677 (KR)
(74) Representative: Appleyard Lees IP LLP
(86) International application number: PCT/KR2023/003101
(87) International publication number: WO 2023/210953

(57) **Abstract**

A display module includes a substrate; a plurality of electrode pads provided on a surface of the substrate; a plurality of first barriers provided between the plurality of electrode pads; and a plurality of light-emitting diodes, each of the plurality of light-emitting diodes including device electrodes connected to corresponding electrode pads of the plurality of electrode pads, wherein each of the plurality of first barriers is provided between a pair of adjacent electrode pads corresponding to a light-emitting diode of the plurality of light-emitting diodes.

## Description

### [Technical Field]

The disclosure relates to a display module.

### [Background Art]

The display panel includes a thin film transistor (TFT) substrate including a plurality of TFTs and a plurality of light-emitting diodes (LEDs) mounted on a substrate.

The plurality of LEDs may be inorganic LEDs that emit light by itself. The plurality of LEDs are operated in units of pixels or sub-pixels and express various colors. Operations of each pixel or subpixel are controlled by a plurality of TFTs. Each LED emits various colors, e.g., red, green, or blue.

The plurality of LEDs may be transferred from a wafer or a relay substrate to a TFT substrate by a pick and place transfer scheme, a stamping transfer scheme, or a laser transfer scheme.

### [Disclosure]

### [Technical Solution]

Provided are a display module and a method for preventing a short between electrode pads of a TFT substrate due to conductive balls of an Anisotropic Conductive Film (ACF).

According to an aspect of the disclosure, a display module includes: a substrate; a plurality of electrode pads provided on a surface of the substrate; a plurality of first barriers provided between the plurality of electrode pads; and a plurality of light-emitting diodes, each of the plurality of light-emitting diodes including device electrodes connected to corresponding electrode pads of the plurality of electrode pads, wherein each of the plurality of first barriers is provided between a pair of adjacent electrode pads corresponding to a light-emitting diode of the plurality of light-emitting diodes.

Each of the plurality of first barriers may have a height that is higher than a height of each of the plurality of electrode pads.

At least one of the plurality of first barriers may have an inclined upper surface.

At least one of the plurality of first barriers may have a first inclined surface that is inclined toward a first electrode pad of a corresponding pair of adjacent electrode pads and a second inclined surface that is inclined toward a second electrode pad of the corresponding pair of adjacent electrode pads.

At least one of the plurality of first barriers may have a first curved surface that extends toward a first electrode pad of a corresponding pair of adjacent electrode pads and a second curved surface that extends toward a second electrode pad of the corresponding pair of adjacent electrode pads.

At least one of the plurality of first barriers may have a curved upper surface.

Each of the plurality of first barriers may include an insulation material.

Each of the plurality of first barriers may further include: a body including an organic material; and a first thin film including an inorganic material and covering the body.

Each of the plurality of first barriers may further include a second thin film provided between the substrate and the body.

The display module may further include at least one second barrier disposed between a first pair of adjacent electrode pads of the plurality of electrode pads and a second pair of adjacent electrode pads of the plurality of electrode pads, the first pair of adjacent electrode pads being adjacent to the second pair of adjacent electrode pads, and a height of the at least one second barrier is higher than a height of each of the plurality of electrode pads.

The height of the at least one second barrier may be lower than or equal to a height of each of the plurality of first barriers.

The at least one second barrier may have an inclined upper surface.

The at least one second barrier may have a curved upper surface.

The at least one second barrier may include an insulation material.

The display module may further include a third barrier surrounding the plurality of electrode pads and connected to the plurality of first barriers and the at least one second barrier, and a height of the third barrier is higher than a height of each of the plurality of electrode pads.

### [Description of Drawings]

FIG. 1 is a block diagram illustrating a display apparatus according to one or more embodiments of the disclosure.
FIG. 2 is a floor plan indicating display panel included in a display apparatus according to one or more embodiments of the disclosure.
FIG. 3 is a diagram illustrating an example of a pixel provided in a display panel according to one or more embodiments of the disclosure.
FIG. 4 is a cross-sectional view taken along with A-A' line of FIG. 3 according to one or more embodiments of the disclosure.
FIG. 5 is a diagram illustrating a first barrier disposed between electrode pads of a TFT substrate according to one or more embodiments of the disclosure.
FIG. 6 is a cross-sectional diagram taken along with B-B' line of FIG. 5 according to one or more embodiments of the disclosure.
FIGS. 7A to 7C are cross-sectional diagrams illustrating various shapes of the first barrier disposed between electrode pads of a substrate according to one or more embodiments of the disclosure.
FIGS. 8 and 9 are cross-sectional views illustrating examples of a first barrier disposed between electrode pads of a substrate by using an inorganic material and an organic material according to one or more embodiments of the disclosure;.
FIG. 10 is a diagram illustrating another example of a pixel provided in a display panel according to one or more embodiments of the disclosure.
FIG. 11 is a cross-sectional diagram illustrating taken along with C-C' line illustrated in FIG. 10 according to one or more embodiments of the disclosure.
FIGS. 12 and 13 are cross-sectional diagrams of various examples of the first barrier and the second barrier disposed between electrode pads of the substrate by using an inorganic material and an organic material according to one or more embodiments of the disclosure.
FIG. 14 is a diagram illustrating a still another example of a pixel provided in a display panel according to one or more embodiments of the disclosure.
FIG. 15 is a cross-sectional diagram taken along with D-D' line of FIG. 14 according to one or more embodiments of the disclosure.
FIGS. 16 to 18 are cross-sectional diagrams illustrating that the first barrier and the second barrier disposed between the electrode pads of the substrate and the third barrier surrounding the electrode pads are formed by using an inorganic material and an organic material according to one or more embodiments of the disclosure.

### [Mode for Invention]

Hereinafter, various embodiments will be described in detail with reference to the accompanying drawings. The embodiments described herein may be variously modified. Specific embodiments are depicted in the drawings and may be described in detail in the description of the disclosure. However, it is to be understood that the particular embodiments disclosed in the appended drawings are for ease of understanding of various embodiments. Therefore, it is intended that the invention not be limited to the particular embodiments disclosed in the accompanying drawings, but on the contrary, the intention is to cover all equivalents or alternatives falling within the spirit and scope of the disclosure.

Terms such as "first," "second," and the like may be used to describe various components, but the components should not be limited by the terms. The terms are used to distinguish a component from another.

It is to be understood that the terms such as "comprise" or "consist of" are used herein to designate a presence of a characteristic, number, step, operation, element, component, or a combination thereof, and do not to preclude a presence or a possibility of adding one or more of other characteristics, numbers, steps, operations, elements, components or a combination thereof. It will be understood that when an element is referred to as being "coupled" or "connected" to another element, there may be other elements in the middle, although it may be directly coupled or connected to the other element. In contrast, when an element is referred to as being "directly coupled to" or "directly connected to" another element, there are no elements present therebetween.

In the disclosure, "the same" may refer to components that are matched as well as those that may be different within an extent of the processing error range.

When it is decided that a detailed description for the known art related to the disclosure may unnecessarily obscure the gist of the disclosure, the detailed description may be shortened or omitted.

A display module may include a display panel with an inorganic light-emitting diode (LED) for displaying images. The display panel may be a flat panel display panel or a curved display panel, and include a plurality of inorganic LEDs (e.g., micro LED or mini LED) which may be about one hundred (100) micrometers or below, providing better contrast, response time and energy efficiency compared to Liquid Crystal Display (LCD) panels that require backlight.

The inorganic LED of the disclosure has brightness, luminous efficiency, and lifetime longer than the organic LED (OLED). The inorganic LED may be a semiconductor chip capable of emitting light by itself when power is supplied.

The micro LED, which is an inorganic LED, has a fast reaction rate, low power, and high luminance. For example, the micro LED has a higher efficiency for converting electricity to photons compared to an LCD or an OLED display. That is, the "brightness per Watt" is greater as compared to LCD or OLED displays.

The micro LED may provide the same brightness while consuming less (e.g., substantially half) energy as the LED exceeding one hundred (100) µm or OLED. In addition to the foregoing, the micro LEDs are capable of providing high resolution, outstanding color, contrast and brightness. The micro LEDs may accurately provide a wide range of colors, and may provide a clear screen even in the outdoors under direct and bright sunlight.

In addition, the micro LEDs are resistant to burn-in phenomenon, and generate less heat, thereby improving product lifespan and reducing deformation. The micro LEDs may have a flip-chip structure in which an anode electrode and a cathode electrode are formed on the same first surface and a light emitting surface is formed on a second surface opposite to a first surface on which the electrodes are formed.

The target substrate may be disposed with a Thin Film Transistor (TFT) layer formed of a TFT circuit on the front surface, and a power supply circuit to supply power to the TFT circuit and data driving driver, a gate drive driver and a timing controller to control each drive driver may be disposed on a rear surface. A plurality of pixels arranged in the TFT layer may be driven by a TFT circuit.

The TFT of the display module may be a Low-Temperature Polycrystalline Silicon (LTPS) TFT, a Low-Temperature Polycrystalline Oxide (LTPO) TFT, or an oxide TFT.

The target substrate may be a glass substrate, a synthetic resin series having a flexibility material (for example, Polyimide (PI), Polyethylene Terephthalate (PET), Polyethersulfone (PES), Polyethylene Naphthalate (PEN), Polycarbonate (PC), etc.) or a ceramic substrate.

A TFT layer formed with a TFT circuit may be disposed on a front surface of the target substrate, and a circuit may not be disposed on a rear surface of the target substrate. The TFT layer may be integrally formed on the target substrate or may be manufactured in a separate film form to be attached to one surface of the glass substrate.

The front surface of a target substrate may be divided into an active region and an inactive region. The active region may correspond to a region occupied by the TFT layer on the front surface of the target substrate, and the inactive region may be a region excluding a region occupied by the TFT layer on the front surface of the target substrate.

The edge region of the target substrate may be the outermost region of the glass substrate. The edge region of the target substrate may be a remaining region except for the region in which the circuit of the target substrate is formed. The edge region of the target substrate may also include a portion of the front surface of the target substrate adjacent to the side of the target substrate and a rear surface of the target substrate adjacent to the side of the substrate. The target substrate may be formed of a quadrangle type. For example, the target substrate may be formed of rectangle or square. The edge region of the target substrate may include at least one of four sides of the glass substrate.

The TFT forming the TFT layer (or the backplane) is not limited to a specific structure or type. In other words, the TFT may be implemented as a low temperature poly silicon (LTPS) TFT, an oxide TFT, a poly silicon or a-silicon TFT, an organic TFT, and a graphene TFT, or the like, and may be applied to a P type (or N-type) Metal-Oxide Semiconductor Field-Effect Transistor (MOSFET) in a Si wafer Complementary Metal Oxide Silicon (CMOS) process.

In the disclosure, a target substrate included in a display module is not limited to a TFT substrate. For example, the target substrate may be a substrate without a TFT layer on which the TFT circuit is formed. In this case, the display module may include a substrate on which the micro IC is separately mounted and only wiring is patterned.

The pixel driving method of the display module may be an Active Matrix (AM) driving method or a Passive Matrix (PM) driving method. The display module may form a pattern of wiring in which each micro LED is electrically connected according to an AM driving method or a PM driving method.

The display module may be installed and applied to wearable devices, portable devices, handheld devices in a single unit, and electronic products or electronic parts requiring various displays, and may be applied to display apparatus such as monitors for Personal Computer (PC), high-resolution Televisions (TVs) and signage (or digital signage), electronic displays, etc. through a plurality of assembly layouts, as a matrix type.

The display module of the disclosure may include an inorganic light-emitting element for displaying a plurality of images arranged on a target substrate having a thin film transistor formed on one surface thereof. The plurality of inorganic light-emitting elements may be subpixels constituting a single pixel. In the disclosure, one "LED," "light-emitting diode," one "micro LED," and one "sub-pixel" may be interchangeably used.

Here, the disclosure will be described in detail with reference to the accompanying drawings so that those skilled in the art can easily implement the embodiment. However, the disclosure may be implemented in various different forms and is not limited to the embodiments described herein. In order to clearly describe the disclosure in the drawings, parts which are not related to the description have been omitted, and like reference numerals refer to similar parts throughout the specification.

Further, embodiments of the disclosure are described in detail with reference to the accompanying drawings and the contents disclosed in the accompanying drawings, but the disclosure is not limited or restricted by embodiments.

Here, a display apparatus according to one or more embodiments of the disclosure will be described with reference to drawings.

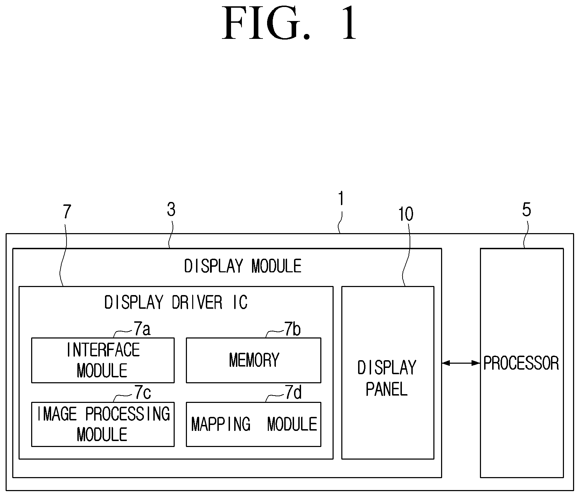

FIG. 1 is a block diagram illustrating a display apparatus according to one or more embodiments of the disclosure.

Referring to FIG. 1, a display apparatus 1 according to an embodiment may include a display module 3 and a processor 5.

The display module 3, according to one or more embodiments of the disclosure, may display various images. Here, the image may be a still image and/or a video. The display module 3 may display various images such as broadcast content, multimedia content, and the like. In addition, the display module 3 may display a user interface and an icon. The display module 3 includes a display panel 10 and a display driver integrated circuit (IC) 7 for controlling the display panel 10.

The display driver IC 7 includes an interface module 7a, a memory 7b (e.g., a buffer memory), an image processing module 7c, and a mapping module 7d.

The display driver IC 7 may receive image information including image data, or an image control signal corresponding to a command for controlling the image data from another component of the display apparatus 1 through the interface module 7a. The image information may be received from the processor 5 (e.g., a main processor, an Application Processor (AP)) or the secondary processor 44 (e.g., a Graphic Processing Unit (GPU)) operating independently of the function of the processor 5 (e.g., the main processor).

The display driver IC 7 may store at least a part of the received image information in the memory 7b, for example, in a frame unit. The image processing module 7c may perform pre-processing or post-processing (e.g., resolution, brightness, or size adjustment) for at least a part of the image data based on at least one of the characteristics of the image data or characteristics of the display panel 10. The mapping module 7d may generate a voltage value or a current value corresponding to the image data pre-processed or post-processed through the image processing module 7c. The generation of a voltage value or current value may be performed based at least in part on an attribute of pixels of the display panel 10 (e.g., an array of pixels (an RGB stripe or a PenTile structure), or a size of each of the subpixels). At least some pixels of the display panel 10 may be driven based at least in part on the voltage value or current value such that visual information (e.g., text, an image, or an icon) corresponding to the image data may be displayed through the display panel 10.

The display deriver IC 7 may transmit a driving signal (e.g., a driver driving signal, a gate driving signal, etc.) to a display based on image information received from the processor 5.

The display driver IC 7 may display an image based on the image signal received from the processor 5. For example, the display driver IC 7 may generate a driving signal of a plurality of sub-pixels based on an image signal received from the processor 5, and display an image by controlling light emissions of the plurality of sub-pixels based on the driving signal.

The display module 3 may further include a touch circuit. The touch circuit may include a touch sensor and a touch sensor IC for controlling the same. The touch sensor IC may control the touch sensor to detect a touch input or hovering input for the designated position of the display panel 10.

The touch sensor IC may detect a touch input or hovering input by measuring the change in the signal (e.g., voltage, light amount, resistance, or charge) for the designated position of the display panel 10. The touch sensor IC may provide information about the detected touch input or hovering input (e.g., location, area, pressure, or time) to the processor 5. At least part of the touch circuit (e.g., the touch sensor IC) may be included as part of the display driver IC 7, or as part of the display panel 10, or other components (e.g., a sub-processor) placed outside of the display module 3.

The processor 5 may be implemented with a Digital Signal Processor (DSP) for processing of a digital signal, a microprocessor, a Time Controller (TCON), or the like. The processor 5 may include one or more among a Central Processor (CPU), a Micro Controller Unit (MCU), a Micro Processor Unit (MPU), a controller, an application processor (AP), a Communication Processor (CP), an Advanced Reduced instruction set computing machine (ARM) processor, a dedicated processor, or may be defined as a corresponding term. The processor 5 may be implemented in a System-on-Chip (SoC) type or a Large Scale Integration (LSI) type which a processing algorithm is built therein, Application Specific Integrated Circuit (ASIC), or in a Field Programmable Gate Array (FPGA) type.

The processor 5 may control hardware or software components coupled to the processor 5 by driving an operating system or an application program, and may perform various data processing and operations. Further, the processor 5 may load and process commands or data received from at least one of the other components into the volatile memory and store the various data in the non-volatile memory.

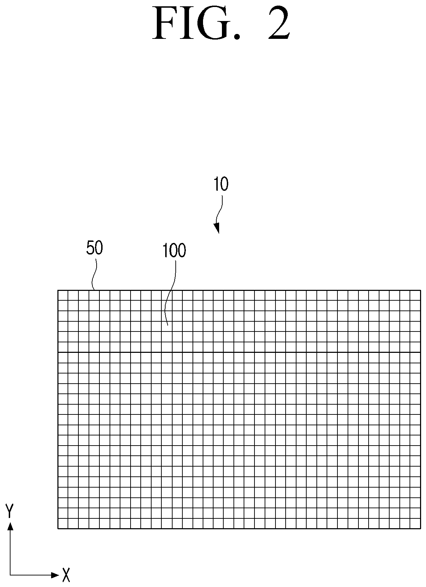

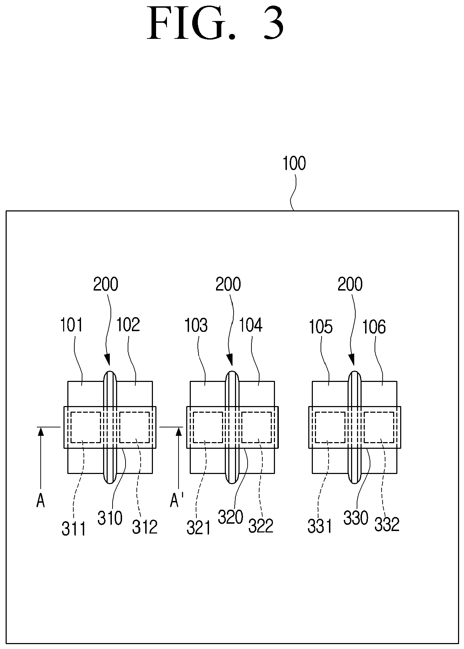

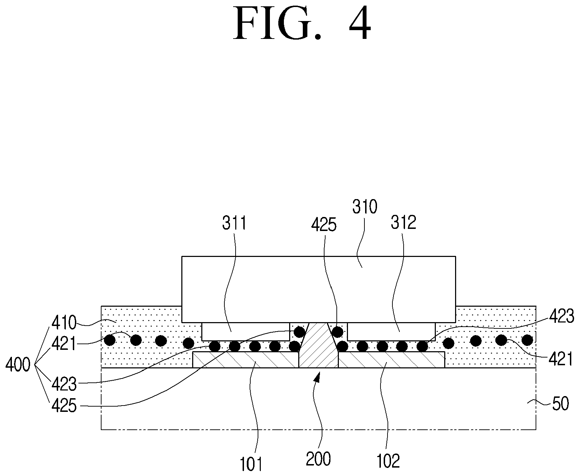

FIG. 2 is a floor plan indicating display panel included in a display apparatus according to one or more embodiments of the disclosure; FIG. 3 is a diagram illustrating an example of a pixel provided in a display panel according to one or more embodiments of the disclosure; and FIG. 4 is a cross-sectional view taken along with A-A' line of FIG. 3 according to one or more embodiments of the disclosure.

Referring to FIG. 2, the display panel 10 may include a Thin Film Transistor (TFT) substrate 50 and a plurality of pixels mounted on one surface of the TFT substrate 50. Each pixel 100 may include at least three sub-pixels arranged in a corresponding pixel region.

Referring to FIG. 3, one pixel 100 may include a first sub-pixel 310 emitting light of a red wavelength band, a second sub-pixel 320 emitting light of a green wavelength band, and a third sub-pixel 330 emitting light of a blue wavelength band.

In the disclosure, a subpixel may be a micro LED or a mini LED, which is an inorganic LED having a size of less than one hundred (100) µm. Hereinafter, the sub-pixel is referred to as a micro LED.

One pixel 100 may include a plurality of TFTs for driving the first, second, and third micro LEDs 310, 320, 330 in a region not occupied by the first micro LED 310, the second micro LED 320, and the third micro LED 330.

The first, second, and third micro LED 310, 320, 330 may be arranged or provided in a line at regular intervals, but are not limited thereto. For example, the first, second, and third micro LED 310, 320, 330 may be arranged in an L shape or arranged in a PenTile RGBG method. The PenTile RGBG scheme is a scheme in which red, green, and blue subpixels are arranged at a ratio of 1: 1: 2 (R:B:G) by using a characteristic that a human may less identify a blue color and best identify a green color. The PenTile RGBG method may increase yield, decrease unit cost, and implement high resolution on a small screen, thereby being effective.

The display module 3 may be a touch screen coupled with a touch sensor, a flexible display, a rollable display, and/or a three-dimensional (3D) display. In addition, according to an embodiment, a plurality of display modules of the disclosure may be provided, and the modules may be physically connected to implement a large display (for example, a Large Format Display (LFD)).

The TFT substrate 50 may be implemented in the form of Amorphous Silicon (a-Si) TFT, Low Temperature Polycrystalline Silicon (LTPS) TFT, Low Temperature Polycrystalline Oxide (LTPO) TFT, Hybrid Oxide and Polycrystalline silicon (HOP) TFT, Liquid Crystalline Polymer (LCP) TFT, or Organic TFT (OTFT).

Referring to FIG. 3, a plurality of electrode pads may be arranged on the TFT substrate 50. For example, as illustrated in FIG. 3, one pixel 100 may include a pair of first electrode pads 101 in which first, second, and third micro LEDs 310, 320, 330, are electrically connected, respectively, a pair of second electrode pads 103, 104 and a pair of third electrode pads 105, 106.

A pair of first electrode pads 101, 102 may be respectively and electrically connected to a pair of first device electrodes 311, 312 provided on one surface of the first micro LED 310. The first micro LED 310 is a flip chip type LED, and the opposite surface of the surface on which the pair of first device electrodes 311, 312 are arranged may be a light emitting surface.

The pair of second electrode pads 103, 104 may be electrically connected to a pair of second device electrodes 321, 322 provided on one surface of a second micro LED 320, respectively. The pair of third electrode pads 105, 106 may be respectively and electrically connected to a pair of third device electrodes 331, 332 provided on one surface of the third micro LED 330. Like the first micro LED 310, the second micro LED 320 and the third micro LED 330 may be flip chip type LEDs.

Referring to FIG. 4, a first micro LED 310 may be connected to the TFT substrate 50 through an Anisotropic Conductive Film (ACF) 400 covering one surface of the TFT substrate 50.

The ACF 400 may include a resin 410 made of a thermosetting material (e.g., an epoxy resin, polyurethane or acrylic resin), and a plurality of conductive balls 421, 423, 425 having conductivity with a diameter of 3-15 µm. In one embodiment, the plurality of conductive balls 421, 423, and 425 may occupy approximately 0.5% to 5% of the total volume of the ACF 400. The plurality of conductive balls 421, 423, and 425 may be formed of polymer particles and a metal film (e.g., gold (Au), nickel (Ni), or lead (Pd)) through which coated electricity is applied to the outer circumferential surface of the polymer particles.

The first micro LED 310 may be transferred from a relay substrate to the TFT substrate 50. In this case, a pair of first device electrodes 311, 312 of the first micro LED 310 may be mounted on the ACF 400 covering the TFT substrate 50 and disposed at a position corresponding to the pair of first electrode pads 101, 102 of the TFT substrate 50.

In this state, the first micro LED 310 is pressed toward the TFT substrate 50 by a preset pressure through a thermal compression process. At this time, high-temperature heat may be transferred to the ACF 400. Accordingly, the resin 410 of the ACF 400 has fluidity and moves to both sides of the first barrier 200.

The plurality of conductive balls 425 positioned on the upper side of the first barrier 200 are moved to both sides of the first barrier 200 together with the flowing resin 410 by the resin flow as described above. The first barrier 200 may be disposed between the pair of first electrode pads 101, 102 and may be formed of an insulating material.

The plurality of conductive balls 423, 425 are positioned between one first electrode pad 101 and one first device electrode 311 corresponding to the one first electrode pad 101. The plurality of conduct balls 423, 425 are also positioned between the remaining first electrode pad 102 and the remaining first device electrode 312 corresponding to the remaining first electrode pad 102.

The pair of first device electrodes 311, 312 of the first micro LED 310 may be electrically connected to the pair of first electrode pads 101, 102 of the TFT substrate 50 through a plurality of conductive balls 423.

In one embodiment, the pair of first device electrodes 311, 312 of the first micro LED 310 are not short-circuited to each other by the first barrier 200, and the pair of first electrode pads 101, 102 are not short-circuited to each other by the first barrier 200.

Hereinafter, the structure of the first barrier 200 according to the disclosure will be described in detail.

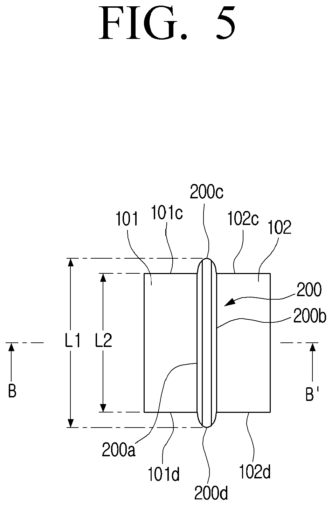

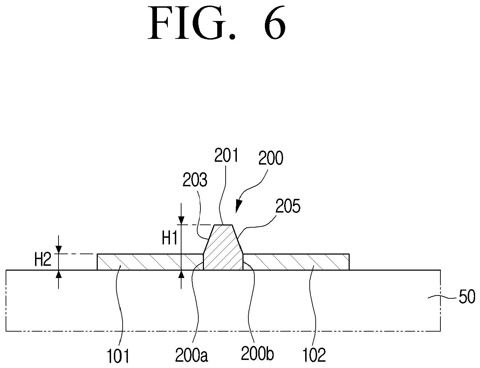

FIG. 5 is a diagram illustrating a first barrier disposed between electrode pads of a TFT substrate; FIG. 6 is a cross-sectional diagram taken along with B-B' line of FIG. 5.

Referring to FIG. 5, the first barrier 200 may be formed on one surface of a TFT substrate 50 and may be disposed between a pair of first electrode pads 101, 102. As shown in FIG. 5, a left side 200a and a right side 200b of the first barrier 200 are in close contact with the pair of first electrode pads 101 and 102, respectively.

However, the embodiment is not limited thereto, and only one of the left side 200a and the right side 200b of the first barrier 200 may be in close contact with only one of the pair of first electrode pads 101, 102. In addition, both the left side 200a and the right side 200b of the first barrier 200 may be spaced apart from the pair of first electrode pads 101, 102.

The length L1 of the first barrier 200 may be configured to prevent the pair of first device electrodes 311 and 312 (e.g., shown in FIG. 4) from being short-circuited by a plurality of conductive balls of the ACF 400, and prevent the pair of first electrode pads 101 and 102 from being short-circuited to each other.

For example, the length L1 of the first barrier 200 may be longer than the length L2 of the pair of first electrode pads 101 and 102. In this case, as shown in FIG. 5, the first barrier 200 may protrude further than front ends 101c and 102c of the pair of first electrode pads 101 and 102. The rear end 200d may protrude further than rear ends 101d and 102d of the pair of first electrode pads 101 and 102.

However, the embodiment is not limited thereto, and the front end 200c of the first barrier 200 may be at a position corresponding to the front ends 101c, 102c of the pair of first electrode pads 101, 102. Alternatively, the rear end 200d of the first barrier 200 may be at a position corresponding to the rear ends 101d, 102d of the pair of first electrode pads 101, 102. Alternatively, the front end 200c and the rear end 200d of the first barrier 200 may be at positions corresponding to the front ends 101c, 102c and the rear ends 101d, 102d of the pair of first electrode pads 101, 102, respectively.

Referring to FIG. 6, the first barrier 200 may include an upper end 201 formed to be approximate a plane and a first inclined surface 203 and a second inclined surface 205, which are extended to be inclined at a predetermined angle to the left side and the right side.

The first inclined surface 203 and the second inclined surface 205 may guide the resin 410 of the ACF 400 (e.g., shown in FIG. 4) and the plurality of conductive balls included in the resin 410 to smoothly move to the left and right sides of the first barrier 200 during the thermal compression process.

The first inclined surface 203 or the second inclined surface 205 may guide one of the pair of first device electrodes of the first micro LED 310, which is pressed toward the TFT substrate 50, to a connection position during a thermal compression. This may correspond to a case in which the pair of first device electrodes 311, 312 of the first micro LED 310 are not aligned with the pair of first electrode pads 101, 102 of the TFT substrate 50 but slightly shifted to the left or right.

A height H1 from a top surface of the TFT substrate 50 to an upper end of the first barrier 200 may be greater than a height H2 from an upper surface of the TFT substrate 50 to an upper end of the pair of first electrode pads 101 and 102. As such, a plurality of conductive balls 425 disposed on the left and right sides of the first barrier 200 may be isolated without being connected to each other.

Since the height H1 of the first barrier 200 is higher than the height H2 of the pair of first electrode pads 101, 102, the pair of first electrode pads 101, 102 may be protected from an impact applied from outside, such as scratches by the first barrier 200.

A plurality of first barriers 200 is provided or arranged between the pair of first electrode pads 101, 102, between the pair of second electrode pads 103, 104, or between the pair of third electrode pads 105, 106 as shown in FIG. 3.

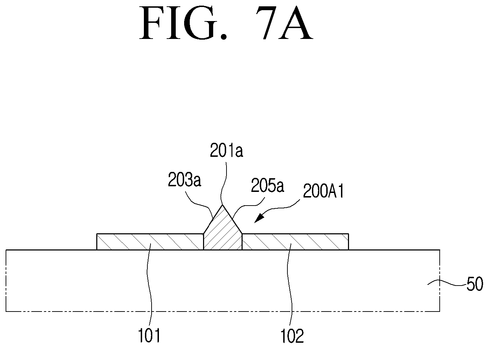

The cross-sectional shape of the first barrier 200 is not limited to the shape illustrated in FIG. 6 and may be diverse. Hereinafter, embodiments of various cross-sectional shapes of the first barrier 200 will be described with reference to FIGS. 7A to 7C. The first barrier shown in FIGS. 7A-7C is substantially the same as the first barrier 200 (see FIG. 6) described above and may have different cross-sectional shapes.

FIGS. 7A to 7C are cross-sectional diagrams illustrating various shapes of the first barrier disposed between electrode pads of a substrate.

Referring to FIG. 7A, the first barrier 200A1 according to an embodiment may include the first inclined surface 203a and the second inclined surface 205a having an upper end 201a being in an edge shape and extending in an inclined manner at a predetermined angle to the left side and the right side of the first barrier 200A1 from the upper end 201a.

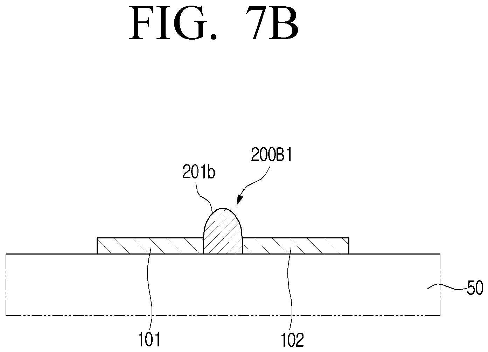

Referring to FIG. 7B, the first barrier 200B1 according to an embodiment may have an upper portion 201b formed as a curved surface having a predetermined curvature. The upper portion 201b of the first barrier 200B1 may include a left side and a right side extended by a predetermined length from the upper end of the first barrier 200B1 to the left side and the right side of the first barrier 200B1.

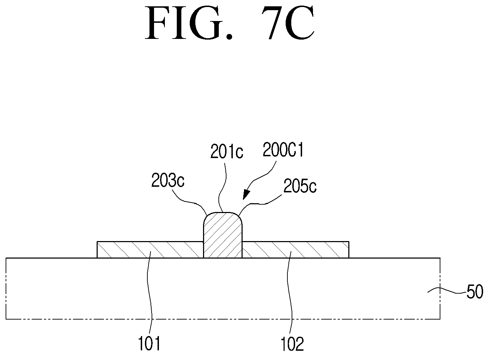

Referring to FIG. 7C, the first barrier 200C1 according to an embodiment may include a first inclined surface 203c and a second inclined surface 205c having an upper end 201c being about a flat surface and extending in a curved shape from an upper end 201c to the left side and the right side of the first barrier 200C1, respectively.

The first barriers 200 (200A1, 200B1, and 200C1) having the cross-sectional shape as described above may guide the resin 410 and the conductive balls 425 to smoothly move to the left and right sides of the first barriers 200 (200A1, 200B1, and 200C1) during the thermal compression process.

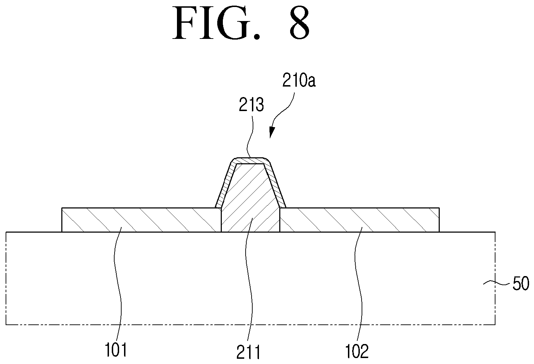

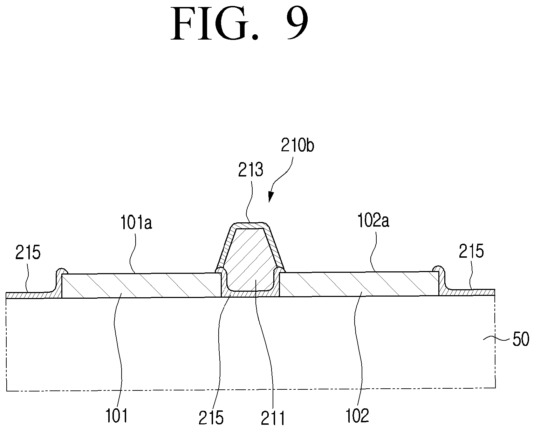

FIGS. 8 and 9 are cross-sectional views illustrating examples of a first barrier disposed between electrode pads of a substrate by using an inorganic material and an organic material.

The material of the first barrier 200 according to an embodiment may be made of an organic and inorganic material having insulating properties. In addition, the material of the first barrier 200 may have a black color capable of absorbing light. Accordingly, the first barrier 200 may absorb light incident on the display panel 10 to improve light efficiency and color reproducibility of the display apparatus.

Referring to FIG. 8, the first barrier 210a according to an embodiment may include a body 211 made of an organic material and a first thin film 213 made of an inorganic material.

The overall shape of the first barrier 210a may be determined by the shape of the body 211 of the first barrier 210a. The body 211 of the first barrier 210a may form a step between the first barrier 210a and the pair of the first electrode pads 101, 102 of the TFT substrate 50. In one embodiment, the height of the first barrier 210a is relatively higher than the height of the pair of first electrode pads 101, 102, the pair of first electrode pads 101, 102 of the TFT substrate 50 may be protected from external impacts such as scratches.

The first thin film 213 of the first barrier 210a may cover the exposed part of the body 211 of the first barrier 210a. In one embodiment, the first thin film 213 of the first barrier 210a is made of an inorganic material, the body 211 of the first barrier 210a may be protected from moisture.

Referring to FIG. 9, the first barrier 210b according to an embodiment includes a body 211 and a first thin film 213, such as in the first barrier 210a (see FIG. 8) described above. The first barrier 210b may further include a second thin film 215, which is different from the first barrier 210a (see FIG. 8) described above.

In one embodiment, the second thin film 215 of the first barrier 210b may be made of an inorganic material. The second thin film 215 of the first barrier 210b may be formed on the TFT substrate 50 before the body 211 is formed. In this case, the second thin film 215 of the first barrier 210b may be formed on the TFT substrate 50 not to cover upper surfaces of the pair of first electrode pads 101, 102.

In one embodiment, the second thin film 215 of the first barrier 210b is located between the body 211 of the first barrier 210b and the upper surface of the TFT substrate 50. In one embodiment, the body 211 of the first barrier 210b may be formed on the second thin film 215 formed between the pair of first electrode pads 101, 102.

The coupling force between the body 211 of the first barrier 210b and the second thin film 215 of the first barrier 210b may be greater than the coupling force between the body 211 of the first barrier 210b and the surface of the TFT substrate 50. Therefore, the body 211 of the first barrier 210b may be firmly coupled to the surface of the TFT substrate 50 indirectly through the second thin film 215 of the first barrier 210b.

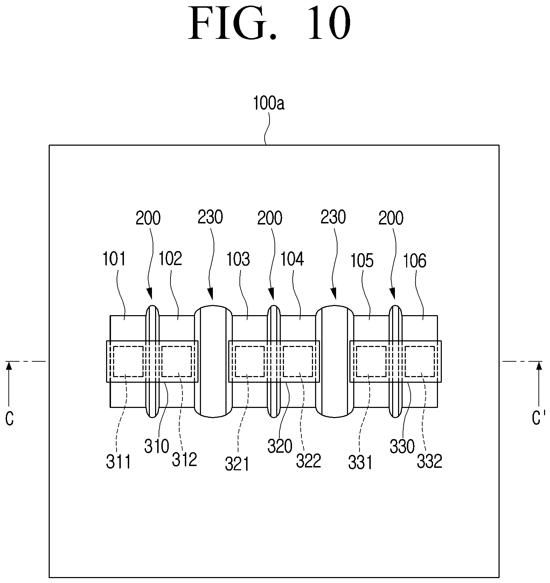

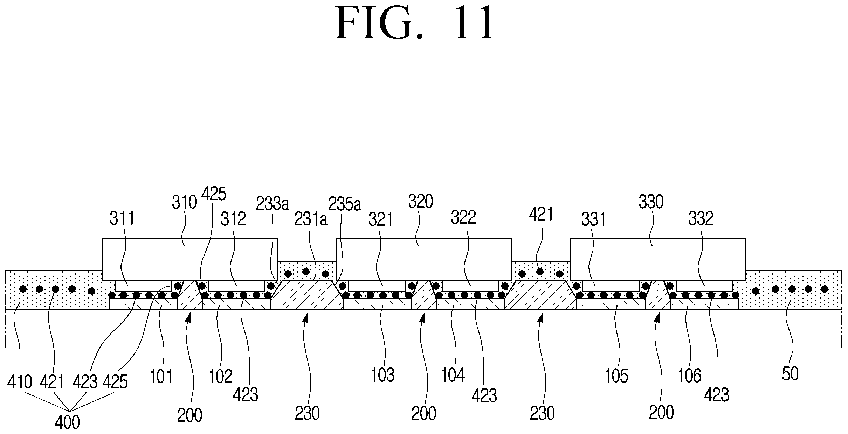

FIG. 10 is a diagram illustrating another example of a pixel provided in a display panel according to one or more embodiments of the disclosure. FIG. 11 is a cross-sectional diagram illustrating taken along with C-C' line illustrated in FIG. 10 according to one or more embodiments of the disclosure.

Referring to FIG. 10, a plurality of second barriers 230 may be disposed together with the plurality of first barriers 200 in the pixel 100a of a display panel according to one or more embodiments of the disclosure.

The plurality of first barriers 200 may be arranged between the pair of first electrode pads 101, 102, between the pair of second electrode pads 103, 104, and between the pair of third electrode pads 105, 106.

In FIG. 10, the length and the height of the plurality of first barriers 200 arranged in the pixel 100a according to an embodiment may be substantially the same as the length and height of the plurality of first barriers 200 arranged in the aforementioned pixel 100 (in FIG. 3). The cross-sectional shape of the plurality of first barriers 200 disposed in the pixel 100a according to an embodiment may be substantially the same as the cross-sectional shape of the plurality of first barriers 200 disposed in the pixel 100 (in FIG. 3) described above.

In one embodiment, the plurality of second barriers 230 may be arranged between the pair of first electrode pads 101, 102 and the pair of second electrode pads 103, 104, and between the pair of second electrode pads 103, 104 and the pair of third electrode pads 105, 106. In one embodiment, as illustrated in FIG. 10, one of the plurality of second barriers 230 may be disposed between the first electrode pad 102 and the second electrode pad 103 adjacent to the first electrode pad 102. The other of the plurality of second barriers 230 may be disposed between the second electrode pad 104 and the third electrode pad 105 adjacent to the second electrode pad 104.

In one embodiment, the length and the height of the plurality of second barriers 230 may be respectively substantially the same as the length and the height of the plurality of first barriers 200. In one embodiment, the width of the plurality of second barriers 230 may be greater than the width of the plurality of first barriers 200.

Referring to FIG. 11, the pair of first device electrodes 311, 312 of the first micro LED 310 may be electrically connected to the pair of first electrode pads 101, 102 of the TFT substrate 50 through a plurality of conductive balls 423. The pair of second device electrodes 321, 322 of the second micro LED 320 may be electrically connected to a pair of second electrode pads 103, 104 of the TFT substrate 50 through the plurality of conductive balls 423. A pair of third device electrodes 331, 332 of the third micro LED 330 may be electrically connected to the pair of third electrode pads 105, 106 of the TFT substrate 50 through the plurality of conductive balls 423.

The plurality of first barriers 200 isolates the plurality of conductive balls 425 from the left and right sides. Accordingly, a short between the pair of first electrode substrates 101, 102, a short between the pair of second electrode substrates 103, 104, and a short between the pair of third electrode substrates 105, 106 may be prevented by the plurality of conductive balls 425. In addition, due to the plurality of conductive balls 425, a short between a pair of second device electrodes 321, 322 of the second micro LED 320 and a short between a pair of third device electrodes 331, 332 of the third micro LED 330 may be prevented.

The plurality of second barriers 230 may prevent a short between adjacent electrode pads 102, 103 due to the plurality of conductive balls and a short between adjacent electrode pads 104, 105.

Each of a plurality of second barriers 230 has an upper end 231a formed as a plane, and a first inclined surface 233a and a second inclined surface 235a may be formed on the left and right sides. During the thermal compression process, the resin 410 of the ACF 400 may move to the left and right sides of the second barrier 230 along the first and second inclined surfaces 233a, 235a of the plurality of second barriers 230 while the resin 410 of the ACF 400 has fluidity due to high temperature heat transferred to the ACF 400. At this time, some conductive balls may be moved to the electrode pads (the first electrode pad 102, the pair of second electrode pads 103, 104, and the third electrode pad 105) on the first and second inclined surfaces 233a, 235a of the plurality of second barriers 230 together with the resin 410.

The plurality of second barriers 230 are not limited to a cross-sectional shape having first and second inclined surfaces 233a, 235a on an upper portion thereof, and may have a cross-sectional shape in which upper left and right sides of the plurality of second barriers 230 are formed in a curved surface.

When the pairs of first, second, and third device electrodes 311, 312, 321, 322, 331, 332 of the first, second, and third micro LEDs 310, 320, 330 are not aligned with the pairs of first, second, and third electrode pads 101, 102, 103, 104, 105, 106 of the corresponding TFT substrate 50, respectively, and are slightly shifted to the left side or the right side, the first inclined surface 233a and/or the second inclined surface 235a of the second barrier 230 may guide the pairs of first, second, and third device electrodes 311, 312, 321, 322, 331, 332 of the first, second, and third micro LEDs 310, 320, 330) pressed toward the TFT substrate 50 during thermal compression. Accordingly, the connection positions of the first, second, and third micro LEDs 310, 320, 330 may be adjusted.

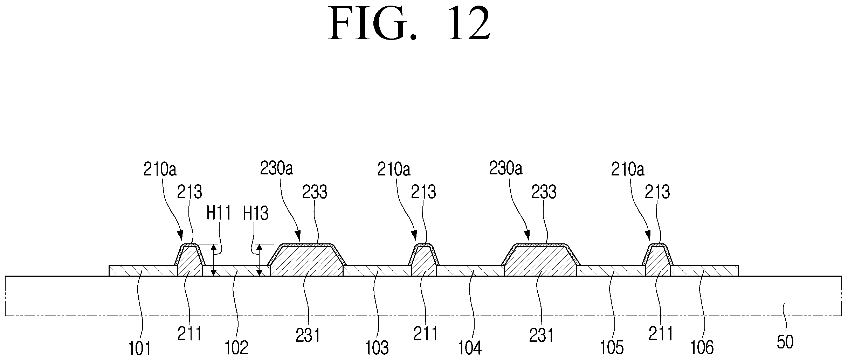

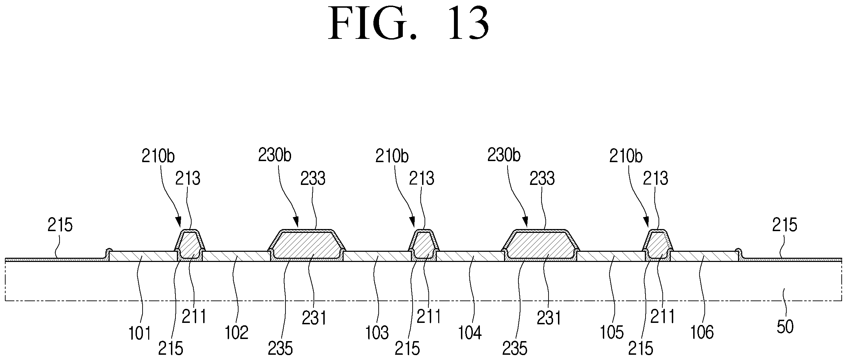

FIGS. 12 and 13 are cross-sectional diagrams of various examples of the first barrier and the second barrier disposed between electrode pads of the substrate by using an inorganic material and an organic material.

The materials of the plurality of first barriers 200 and the second barriers 230 according to an embodiment may be made of organic and inorganic materials having insulating properties. In addition, the material of the first barrier 200 and the second barrier 230 may have a black color capable of absorbing light. Accordingly, the first and second barriers 210, 230 absorb light incident on the display panel 10 to improve light efficiency and color reproducibility of the display apparatus.

Referring to FIG. 12, the plurality of first barriers 210a according to an embodiment may include a body 211 made of an organic material and a first thin film 213 made of an inorganic material. The first thin film 213 of the first barrier 210a may cover the exposed portion of the body 211 of the first barrier 210a.

The plurality of second barriers 230a according to an embodiment may include a body 231 made of an organic material and a first thin film 233 made of an inorganic material. The first thin film 233 of the second barrier 230a may cover the exposed portion of the body 231 of the second barrier 230a.

The body 211 of the plurality of first barriers 210a and the body 231 of the plurality of second barriers 230a may be formed on the TFT substrate 50 in the same process. The first thin film 213 of the plurality of first barriers 210a and the first thin film 233 of the plurality of second barriers 230a may be formed on the body 211 of the first barrier 210a and the body 231 of the plurality of second barriers 230a in the same process.

The height H11 of the plurality of first barriers 210a and the height H13 of the plurality of second barriers 230a may be substantially the same. In this case, the heights H11 and H13 of the plurality of first and second barriers 210a and 230a may be formed to be higher than the heights of the electrode pads 101, 102, 103, 104, 105, and 106. Accordingly, a step (or a gap) may be formed between the first and second barriers 210a, 230a and the electrode pads 101, 102, 103, 104, 105, 106. By this step (or the gap), the plurality of first and second barriers 210a, 230a may protect the electrode pads 101, 102, 103, 104, 105, 106 of the TFT substrate 50 from external impacts such as scratches.

Referring to FIG. 13, the plurality of first barriers 210b according to an embodiment includes the body 211 and the first thin film 213, such as the first barrier 210a (illustrated in FIG. 8) described above. The plurality of first barriers 210b may further include the second thin film 215 different from the plurality of first barriers 210a (FIG. 8) described above.

The second thin film 215 of the plurality of first barriers 210b may be made of an inorganic material. The second thin film 215 of the plurality of first barriers 210b may be formed on the TFT substrate 50 before forming the body 211 of the plurality of first barriers 210b. In this case, the second thin film 215 of the plurality of first barriers 210b formed on the TFT substrate 50 may be disposed between the pair of first electrode pads 101, 102, between the pair of second electrode pads 103, 104, and between the pair of third electrode pads 105, 106.

The plurality of second barriers 230b according to an embodiment includes the body 231 and the first thin film 233, such as the plurality of second barriers 230a (illustrated in FIG. 12) described above. The second barrier 230b may further include the second thin film 235 different from the second barrier 230a (see FIG. 12) described above.

The second thin film 235 of the plurality of second barriers 230b may be made of an inorganic material. The second thin film 235 of the plurality of second barriers 230b may be formed on the TFT substrate 50 before forming the body 231 of the plurality of second barriers 230b. In this case, the second thin film 235 of the plurality of second barriers 230b formed on the TFT substrate 50 may be arranged between adjacent electrode pads 102, 103 and between other adjacent electrode pads 104, 105.

The second film 211 of the plurality of first barriers 210b and the second film 235 of the plurality of second barriers 230b may be formed on the TFT substrate 50 in the same process.

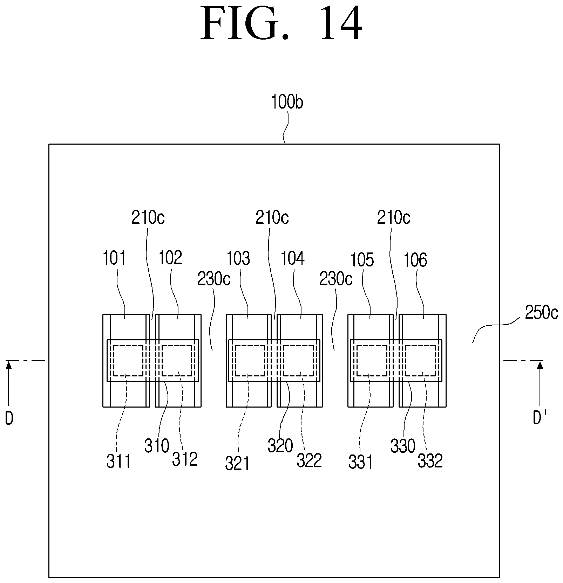

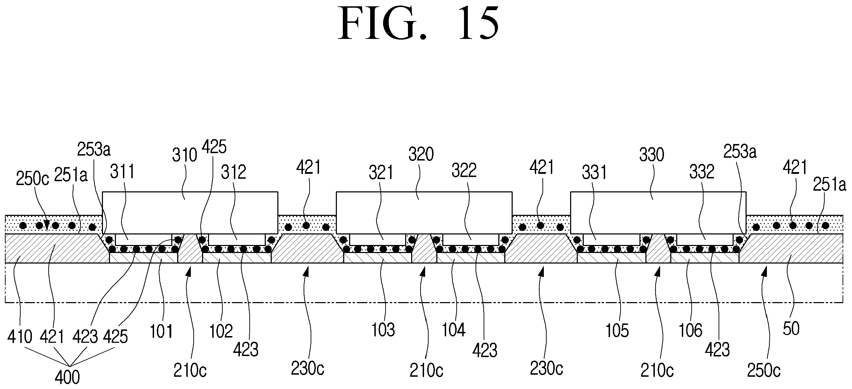

FIG. 14 is a diagram illustrating a still another example of a pixel in a display panel according to one or more embodiments of the disclosure, and FIG. 15 is a cross-sectional diagram taken along with D-D' line of FIG. 14.

Referring to FIG. 14, the third barrier 250c may be disposed together with the plurality of first and second barriers 210c and 230c in a pixel 100b in a display panel according to one or more embodiments of the disclosure.

The plurality of first and second barriers 210c, 230c arranged in the pixel 100b are substantially the same as those of the plurality of first and second barriers 200, 230 (FIG. 10) described above, and thus a description thereof will be omitted.

The third barrier 250c may be formed on the TFT substrate 50 to surround the pairs of first, second, and third electrode pads 101, 102, 103, 104, 105, 106 in one pixel region.

The third barrier 250c may be connected to the plurality of first barriers 210c and the plurality of second barriers 230c. In this case, the TFT substrate 50 may be covered by the first, second, and third barriers 210c, 230c, 250c in a state in which a plurality of electrode pads are exposed.

Referring to FIG. 15, the third barrier 250c may have inclined surfaces 253a formed from the upper end 251a formed as a flat surface to the side in which the first micro LED 310 and the third micro LED 330 are disposed.

The connecting positon of the first and third micro LEDs 310, 330 may be adjusted by the inclined surfaces 253a of the third barrier 250c.

For example, when the pairs of first and third device electrodes 311, 312, 331, 323 of the first and third micro LED 310, 330 are not aligned with the pairs of first and third electrode pads 101, 102, 105, 106 of a corresponding TFT substrate 50, respectively and are slightly shifted in the left side or right side, the inclined surfaces 253a of the third barrier 250 may guide the pairs of first and third device electrodes 311, 312, 331, 323 of the first and third micro LEDs 310, 330 pressed toward the TFT substrate 50 during thermal compression. Accordingly, the connection positions of the first, second, and third micro LEDs 310, 320, and 330 may be adjusted.

The materials of the first, second, and third barriers 210c, 230c, and 250c according to an embodiment may be made of organic and inorganic materials having insulating properties. In addition, materials of the first, second, and third barriers 210c, 230c, and 250c may have a black color capable of absorbing light. Accordingly, the first, second, and third barriers 210c, 230c, and 250c absorb light incident on the display panel 10 to improve light efficiency and color reproducibility of the display apparatus.

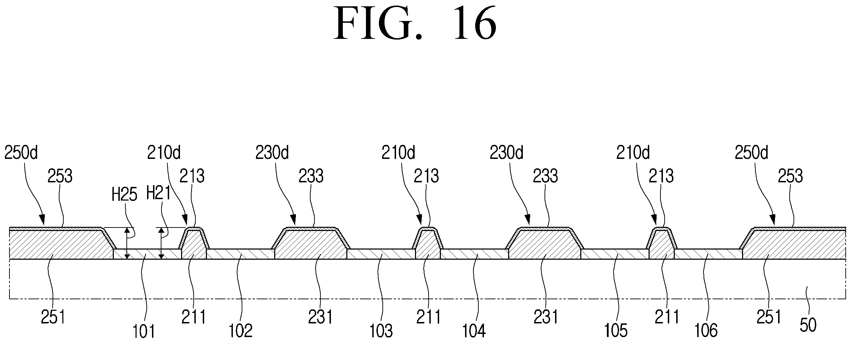

FIGS. 16 to 18 are cross-sectional diagrams illustrating that the first barrier and the second barrier disposed between the electrode pads of the substrate and the third barrier surrounding the electrode pads are formed by using an inorganic material and an organic material.

Referring to FIG. 16, the plurality of first barriers 210d and the plurality of second barriers 230d according to an embodiment are substantially same as those of the first and second barriers 210a and 230a (illustrated in FIG. 12) and a description will be omitted.

The third barrier 250d may include a body 251 made of an organic material and a first thin film 253 made of an inorganic material. The first thin film 253 of the third barrier 250d may cover the exposed portion of the body 251 of the third barrier 250d.

The height H21 of the plurality of first barriers 210d, the height H23 of the plurality of second barriers 230d, and the height H25 of the third barrier 250d may be substantially the same. In this case, heights H21 and H23 of the first and second barriers 210a and 230a and the height H25 of the third barrier 250d may be greater than heights of the electrode pads 101, 102, 103, 104, 105, and 106. Accordingly, a step (or a gap) may be formed between the first and second barriers 210a, 230a and the third barrier 250d and the electrode pads 101, 102, 103, 104, 105, 106. By this step (or the gap), the plurality of first and second barriers 210a, 230a and the third barrier 250d may protect the electrode pads 101, 102, 103, 104, 105, 106 of the TFT substrate 50 from external impacts such as scratches.

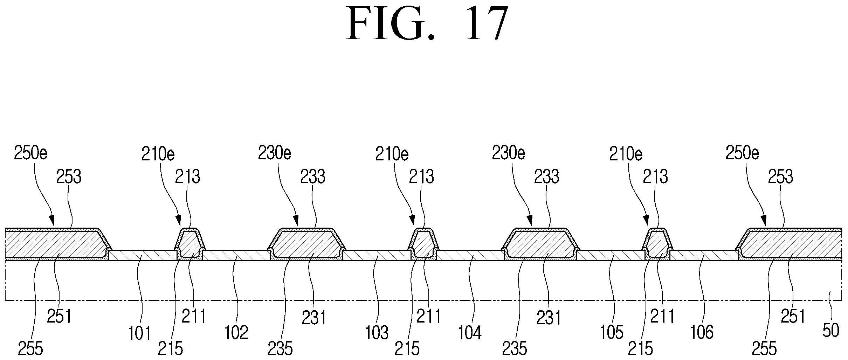

Referring to FIG. 17, the plurality of first barriers 210e and the second barrier 230e have substantially the same structure as the second barrier 210a, 230a (illustrated in FIG. 12) described above and a description will be omitted.

The third barrier 250e according to an embodiment includes the body 251 and the first thin film 253, such as the third barrier 250d (illustrated in FIG. 16) described above. The third barrier 250e may further include a second thin film 255 different from the aforementioned third barrier 250d (see FIG. 16).

The second thin film 255 of the third barrier 250e may be made of an inorganic material. The second thin film 255 of the third barrier 250e may be formed on the TFT substrate 50 before forming the body 251 of the third barrier 250e.

The second thin film 255 of the third barrier 250e may be formed on the TFT substrate 50 in the same process together with the second thin film 211 of the plurality of first barriers 210e and the second thin film 235 of the plurality of second barriers 230e.

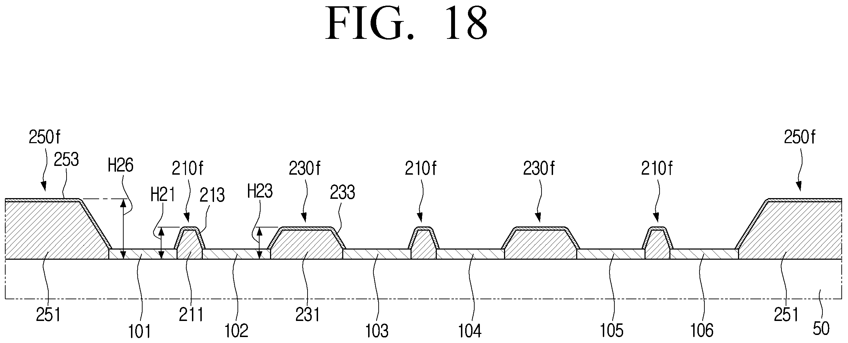

Referring to FIG. 18, the height H26 of the third barrier 250f may be formed higher than the height H21 of the first barrier 210f and the height H23 of the second barrier 230f.

In this case, the height H21 of the first barrier 210f and the height H23 of the second barrier 230f may be substantially the same. In one embodiment, the height H23 of the second barrier 230f may be slightly lower than the height H21 of the first barrier 210f.

The structures of the first barrier 210f, the second barrier 230f, and the third barrier 250f are substantially the same as the structures of the first barrier 210d, the second barrier 230d, and the third barrier 250d shown in FIG. 16, and thus a description thereof will be omitted.

While embodiments of the disclosure have been shown and described, the disclosure is not limited to the aforementioned specific embodiments, and it is apparent that various modifications may be made by those having ordinary skill in the technical field to which the disclosure belongs, without departing from the gist of the disclosure as claimed by the appended claims. Also, it is intended that such modifications are not to be interpreted independently from the technical idea or prospect of the disclosure.

## Claims

1. A display module comprising:
a substrate;
a plurality of electrode pads provided on a surface of the substrate;
a plurality of first barriers provided between the plurality of electrode pads; and
a plurality of light-emitting diodes, each of the plurality of light-emitting diodes comprising device electrodes connected to corresponding electrode pads of the plurality of electrode pads,
wherein each of the plurality of first barriers is provided between a pair of adjacent electrode pads corresponding to a light-emitting diode of the plurality of light-emitting diodes.

2. The display module of claim 1, wherein each of the plurality of first barriers has a height that is higher than a height of each of the plurality of electrode pads.

3. The display module of claim 2, wherein at least one of the plurality of first barriers has an inclined upper surface.

4. The display module of claim 2, wherein at least one of the plurality of first barriers has a first inclined surface that is inclined toward a first electrode pad of a corresponding pair of adjacent electrode pads and a second inclined surface that is inclined toward a second electrode pad of the corresponding pair of adjacent electrode pads.

5. The display module of claim 2, wherein at least one of the plurality of first barriers has a first curved surface that extends toward a first electrode pad of a corresponding pair of adjacent electrode pads and a second curved surface that extends toward a second electrode pad of the corresponding pair of adj acent electrode pads.

6. The display module of claim 2, wherein at least one of the plurality of first barriers has a curved upper surface.

7. The display module of claim 1, wherein each of the plurality of first barriers comprises an insulation material.

8. The display module of claim 7, wherein each of the plurality of first barriers further comprises:
a body comprising an organic material; and
a first thin film comprising an inorganic material and covering the body.

9. The display module of claim 8, wherein each of the plurality of first barriers further comprises a second thin film provided between the substrate and the body.

10. The display module of claim 1, further comprising at least one second barrier disposed between a first pair of adjacent electrode pads of the plurality of electrode pads and a second pair of adj acent electrode pads of the plurality of electrode pads, the first pair of adjacent electrode pads being adjacent to the second pair of adjacent electrode pads, and
wherein a height of the at least one second barrier is higher than a height of each of the plurality of electrode pads.

11. The display module of claim 10, wherein the height of the at least one second barrier is lower than or equal to a height of each of the plurality of first barriers.

12. The display module of claim 11, wherein the at least one second barrier has an inclined upper surface.

13. The display module of claim 11, wherein the at least one second barrier has a curved upper surface.

14. The display module of claim 10, wherein the at least one second barrier comprises an insulation material.

15. The display module of claim 10, further comprising a third barrier surrounding the plurality of electrode pads and connected to the plurality of first barriers and the at least one second barrier,
wherein a height of the third barrier is higher than a height of each of the plurality of electrode pads.
